(19) **Europäisches Patentamt / European Patent Office / Office européen des brevets**

(11) **EP 3 517 586 B1**

(12) # EUROPEAN PATENT SPECIFICATION

(45) Date of publication and mention
of the grant of the patent:
**15.03.2023 Bulletin 2023/11**

(21) Application number: **17852670.3**

(22) Date of filing: **19.07.2017**

(51) International Patent Classification (IPC):
**C09J 7/20** *(2018.01)*      **H01L 21/52** *(2006.01)*
**H01L 21/301** *(2006.01)*      **C09J 7/30** *(2018.01)*
**C09J 7/10** *(2018.01)*

(52) Cooperative Patent Classification (CPC):
(C-Sets available)
**C09J 7/30; C09J 7/10; H01L 21/52;**
C09J 2203/326; C09J 2301/312; C09J 2301/314;
C09J 2400/16; C09J 2400/20; C09J 2400/22;
H01L 2224/48091; H01L 2224/73265;
H01L 2924/181                    (Cont.)

(86) International application number:
**PCT/JP2017/026085**

(87) International publication number:
**WO 2018/055889 (29.03.2018 Gazette 2018/13)**

(54) **HEAT BONDING SHEET, AND HEAT BONDING SHEET WITH DICING TAPE**

WÄRMEVERBINDUNGSFOLIE UND WÄRMEVERBINDUNGSFOLIE MIT SÄGEFOLIE

FEUILLE DE THERMOCOLLAGE, ET FEUILLE DE THERMOCOLLAGE DOTÉE D'UN RUBAN DE DÉCOUPAGE EN DÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.09.2016 JP 2016184320**

(43) Date of publication of application:
**31.07.2019 Bulletin 2019/31**

(73) Proprietor: **Nitto Denko Corporation
Ibaraki-shi, Osaka 567-8680 (JP)**

(72) Inventors:
• **SUGO, Yuki
Ibaraki-shi
Osaka 567-8680 (JP)**
• **HONDA, Satoshi
Ibaraki-shi
Osaka 567-8680 (JP)**

(74) Representative: **Grünecker Patent- und Rechtsanwälte
PartG mbB
Leopoldstraße 4
80802 München (DE)**

(56) References cited:
**EP-A1- 3 358 607      EP-A1- 3 477 688
WO-A1-2016/031551      WO-A1-2016/104188
JP-A- 2013 214 733      JP-A- 2016 121 329
US-A1- 2014 120 356**

**(Cont. next page)**

(52) Cooperative Patent Classification (CPC): (Cont.)

C-Sets
H01L 2224/48091, H01L 2924/00014;
H01L 2924/181, H01L 2924/00012

**Description**

TECHNICAL FIELD

The present invention relates to a thermal bonding sheet and a thermal bonding sheet with dicing tape.

Background Art

In production of semiconductor devices, the method of bonding a semiconductor element to an adherend such as a metallic lead frame (so-called bonding method) has been transited to methods by a solder and a resin paste from the conventional gold-silicon eutectic crystal that has been initially used. At present, a conductive resin paste is sometimes used.

Recently, power semiconductor devices that control or supply electric power have remarkably spread. A power semiconductor device has high calorific power because an electrical current usually flows through the device. Therefore, it is desired for a conductive adhesive that is used in a power semiconductor device to have high heat radiation property and low electric resistivity.

A power semiconductor device is required to operate at high speed with low loss. Conventionally, in a power semiconductor device, a semiconductor using Si such as IGBT (Insulated Gate Bipolar Transistor) or MOSFET (Metal-Oxide-Semiconductor Field-Effect Transistor) has been used. Recently, those using a semiconductor such as SiC or GaN have been developed and expected to extend in the future.

A semiconductor using SiC or GaN is featured by a large band gap and high dielectric breakdown electric field, and can work with low loss, at high speed and high temperature. Operation at high temperature is a merit in automobiles, small power converters and the like that operate in severe thermal environments. Since a semiconductor device having an application in a severe heat environment is assumed to operate at high temperature around 250°C, problems arise in heat characteristics and reliability with a solder or a conductive adhesive that is a conventional bonding/adhering material. In light of this, a paste material containing sinterable metallic particles has been proposed (see, Patent Document 1, for example). The paste material containing sinterable metallic particles contain nano-sized to micro-sized metallic particles, and these metallic particles melt at a temperature that is lower than the normal melting point due to the nano-size effect and sintering between particles progresses.

PRIOR ART DOCUMENTS

PATENT DOCUMENTS

> Patent Document 1: JP-A-2014-111800
> Patent Document 2: JP 2016 121329 A

SUMMARY OF THE INVENTION

PROBLEMS TO BE SOLVED BY THE INVENTION

The paste material containing sinterable metallic particles contains a dispersion medium to maintain the paste form. As the dispersion medium, a volatile dispersion medium is frequently used so as not to inhibit sintering between particles in a sintering step which is a later step. However, in the case of the paste material containing sinterable metallic particles, which contains the volatile dispersion medium, the dispersion medium is volatilized as a paste application step proceeds, which causes a change in an amount of the dispersion medium contained in the paste material after the completion of the application step. If deviation in the existence amount of the dispersion medium occurs, the composition of the paste material becomes nonuniform. As a result, a sintered body having desired characteristics may not be stably obtained in the sintering step.

The present invention has been made in view of the above problems, and it is an object of the present invention to provide a thermal bonding sheet which can suppress a change in composition and stably provide a sintered layer having desired characteristics, and a thermal bonding sheet with dicing tape including the thermal bonding sheet.

MEANS FOR SOLVING THE PROBLEMS

As a result of intensive studies to solve the aforementioned conventional problems, the present inventors found that the problems can be solved by employing the following constitution and accomplished the present invention.

To be more specific, the present invention relates to a thermal bonding sheet including a precursor layer that is to become a sintered layer by heating, wherein a weight reduction rate $\Delta W_0$ (%) and a weight reduction rate $\Delta W_{24}$ (%) satisfy a relationship of a formula (3) below,

the weight reduction rate $\Delta W_0$ (%) being represented by a formula (1) below when the thermal bonding sheet is analyzed in a nitrogen atmosphere at a temperature increase rate of 10°C/min from 23°C to 400°C with a differential thermal balance before the thermal bonding sheet is exposed to an atmosphere having a temperature of $23 \pm 2$°C and a humidity of $50 \pm 20\%$,

the weight reduction rate $\Delta W_{24}$ (%) being represented by a formula (2) below when the thermal bonding sheet is analyzed in a nitrogen atmosphere at a temperature increase rate of 10°C/min from 23°C to 400°C with a differential thermal balance after the thermal bonding sheet is exposed to an atmosphere having a temperature of $23 \pm 2$°C and a humidity of $50 \pm 20\%$ for 24 hours,

$$\Delta W_0 = \{(W_{400} - W_{23})/W_{23}\} \times 100 \ (\%) \ (1)$$

wherein

$W_{23}$ is a weight of the thermal bonding sheet at 23°C before the thermal bonding sheet is exposed to the atmosphere; and

$W_{4C0}$ is a weight of the thermal bonding sheet at 400°C before the thermal bonding sheet is exposed to the atmosphere,

$$\Delta W_{24} = \{(W'_{400} - W'_{23})/W'_{23}\} \times 100 \ (\%) \ (2)$$

wherein

$W'_{23}$ is a weight of the thermal bonding sheet at 23°C after the thermal bonding sheet is exposed to the atmosphere; and

$W'_{400}$ is a weight of the thermal bonding sheet at 400°C after the thermal bonding sheet is exposed to the atmosphere,

$$-1\% \leq \Delta W_0 - \Delta W_{24} \leq 0.5\% \ (3),$$

wherein the precursor layer contains a thermally decomposable binder which is a solid at 23°C, wherein the thermally decomposable binder which is a solid at 23°C is at least one selected from the group consisting of a polycarbonate resin and an acrylic resin, and wherein the precursor layer contains 1,6-hexanediol.

A difference between a heating weight change rate $\Delta W_0$ (%) before the thermal bonding sheet is exposed to a predetermined atmosphere and a heating weight change rate $\Delta W_{24}$ (%) after the thermal bonding sheet is exposed to the predetermined atmosphere for 24 hours is suppressed within a predetermined range, so that the change in the composition of the thermal bonding sheet in a manufacturing process of a semiconductor device can be suppressed. As a result, a sintered layer having desired characteristics can be stably formed.

The precursor layer contains a thermally decomposable binder which is a solid at 23°C. When the precursor layer contains the thermally decomposable binder which is a solid at 23°C, the shape of the sheet can easily be maintained before the thermal bonding step. During the thermal bonding step, thermal decomposition can easily proceed.

The thermally decomposable binder which is a solid at 23°C is at least one selected from the group consisting of a polycarbonate resin and an acrylic resin. When the thermally decomposable binder is such a resin, the thermally decomposable binder can more efficiently exhibit thermal decomposability.

The precursor layer contains the thermally decomposable binder which is a solid at 23°C and an organic component which is liquid at 23°C, which is 1,6-hexanediol. When the precursor layer contains the organic component which is liquid at 23°C, a sheet shape is easily imparted, and the flexibility of the thermal bonding sheet can be enhanced to improve the adhesion between the thermal bonding sheet and an object to be bonded (semiconductor element, adherend or the like).

It is preferable that the organic component which is liquid at 23°C has a vapor pressure at 20°C of 0.1 Pa or less. The configuration can suppress the volatilization of the liquid organic component, and can consequently suppress the change in the composition of the thermal bonding sheet.

In the above configuration, it is preferable that the precursor layer contains metallic fine particles, and the metallic fine particles are made of at least one selected from the group consisting of silver, copper, silver oxide, and copper oxide. This can more suitably provide thermal bonding.

A thermal bonding sheet with dicing tape according to the present invention includes a dicing tape; and the thermal bonding sheet laminated on the dicing tape.

Since the thermal bonding sheet with dicing tape has a structure that a dicing tape and the thermal bonding sheet are integrated, a step for laminating the thermal bonding sheet with the dicing tape can be omitted. Since the thermal bonding sheet is provided, thickness uniformity prevents uneven bonding, which can provide good bonding reliability. The thermal bonding sheet includes the precursor layer, so that the sintered layer obtained by heating the precursor layer becomes strong, which can provide improved high-temperature bonding reliability.

BRIEF DESCRIPTION OF THE DRAWINGS

Fig. 1 is a cross-sectional schematic view showing a thermal bonding sheet with dicing tape according to one embodiment of the present invention.

Fig. 2 is a cross-sectional schematic view showing a thermal bonding sheet with dicing tape according to other embodiment of the present invention.

Fig. 3 is a cross-sectional schematic view showing a thermal bonding sheet with both-side separators.

Fig. 4 is a cross-sectional schematic view for illustrating a method of manufacturing a semiconductor device according to one embodiment of the present invention.

MODE FOR CARRYING OUT THE INVENTION

Hereinafter, embodiments of the thermal bonding sheet and the thermal bonding sheet with dicing tape of the present invention are described by referring to attached drawings. In part or whole of drawings, the part that is unnecessary for description is omitted, and some part is shown while it is scaled up or down for facilitating the description. The term indicating the positional relationship, such as up or down is merely used for facilitating the description and is not intended to limit the constitution of the present invention.

(Thermal bonding sheet with dicing tape)

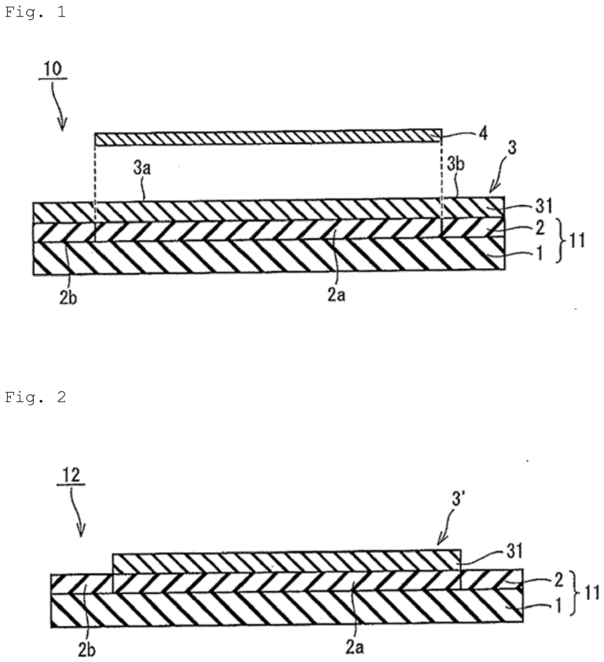

One exemplary thermal bonding sheet according to the present embodiment is in a state that the dicing tape is not bonded in the thermal bonding sheet with dicing tape as will be described below. Therefore, in the following, description is made for the thermal bonding sheet with dicing tape, and the thermal bonding sheet will be described in the description. Fig. 1 is a cross-sectional schematic view showing a thermal bonding sheet with dicing tape according to one embodiment of the present invention. Fig. 2 is a cross-sectional schematic view showing other thermal bonding sheet with dicing tape according to other embodiment of the present invention.

As shown in Fig. 1, a thermal bonding sheet with dicing tape 10 has such a structure that a thermal bonding sheet 3 is laminated on a dicing tape 11. The dicing tape 11 is structured by laminating a pressure-sensitive adhesive layer 2 on a base material 1, and the thermal bonding sheet 3 is disposed on the pressure-sensitive adhesive layer 2. Also, the thermal bonding sheet with dicing tape of the present invention may have such a structure that a thermal bonding sheet 3' is formed only in a work attaching part as in a thermal bonding sheet with dicing tape 12 shown in Fig. 2.

(Thermal bonding sheet)

The thermal bonding sheet 3, 3' is in a sheet form. The sheet form rather than the paste form can provide excellent thickness uniformity and handleability.

The thermal bonding sheet 3, 3' according to the present embodiment includes a precursor layer 31 that is to become a sintered layer by heating. In the present embodiment, description is made for the case where the thermal bonding sheet contains only one layer of a precursor layer that is to become a sintered layer by heating, however, the present invention is not limited to this case. The precursor layer that is to become a sintered layer by heating may have such a structure that a plurality of precursor layers are laminated.

Also, in the present embodiment, description is made for the case where the thermal bonding sheet includes a precursor layer that is to become a sintered layer by heating, however, the present invention is not limited to this case. The thermal bonding sheet of the present invention may include two or more layers. For example, the thermal bonding sheet may have such a structure that a precursor layer that is to become a sintered layer by heating, and other layer (layer that is not to become a sintered layer by heating) are laminated.

That is, it is only required that the thermal bonding sheet according to the present invention has at least a precursor layer that is to become a sintered layer by heating, and other constitution is not particularly limited.

In the thermal bonding sheets 3, 3' according to the present embodiment, a weight reduction rate $\Delta W_0$ (%) and a weight reduction rate $\Delta W_{24}$ (%) satisfy a relationship of the following formula (3), the weight reduction rate $\Delta W_0$ (%) being represented by the following formula (1) when the thermal bonding sheet is analyzed in a nitrogen atmosphere at a temperature increase rate of 10°C/min from 23°C to 400°C with a differential thermal balance before the thermal bonding sheet is exposed to an atmosphere having a temperature of $23 \pm 2$°C and a humidity of $50 \pm 20$%, the weight reduction rate $\Delta W_{24}$ (%) being represented by the following formula (2) when the thermal bonding sheet is analyzed in a nitrogen atmosphere at a temperature increase rate of 10°C/min from 23°C to 400°C with a differential thermal balance after the thermal bonding sheet is exposed to an atmosphere having a temperature of $23 \pm 2$°C and a humidity of $50 \pm 20$% for 24 hours,

$$\Delta W_0 = \{ (W_{400} - W_{23})/W_{23} \} \times 100 \ (\%) \ (1)$$

wherein

$W_{23}$ is a weight of the thermal bonding sheet at 23°C before the thermal bonding sheet is exposed to the atmosphere; and
$W_{400}$ is a weight of the thermal bonding sheet at 400°C before the thermal bonding sheet is exposed to the atmosphere,

$$\Delta W_{24} = \{ (W'_{400} - W'_{23})/W'_{23} \} \times 100 \ (\%) \ (2)$$

wherein

$W'_{23}$ is a weight of the thermal bonding sheet at 23°C after the thermal bonding sheet is exposed to the atmosphere; and
$W'_{400}$ is a weight of the thermal bonding sheet at 400°C after the thermal bonding sheet is exposed to the atmosphere,

$$-1\% \leq \Delta W_0 - \Delta W_{24} \leq 0.5\% \ (3).$$

A difference between a heating weight change rate $\Delta W_0$ (%) before the thermal bonding sheet is exposed to a predetermined atmosphere and a heating weight change rate $\Delta W_{24}$ (%) after the thermal bonding sheet is exposed to the predetermined atmosphere for 24 hours is suppressed within a predetermined range, so that the change in the composition of the thermal bonding sheet in a manufacturing process of a semiconductor device can be suppressed. As a result, a sintered layer having desired characteristics can be stably formed.

In the thermal bonding sheets 3, 3' according to the present embodiment, it is preferable that the difference between the weight reduction rate $\Delta W_0$ (%) and the weight reduction rate $\Delta W_{24}$ (%) satisfies the following formula (3'):

$$-1\% \leq \Delta W_0 - \Delta W_{24} \leq 0\% \ (3').$$

In the thermal bonding sheets 3, 3' according to the present embodiment, it is more preferable that the difference between the weight reduction rate $\Delta W_0$ (%) and the weight reduction rate $\Delta W_{24}$ (%) satisfies the following formula (3"):

$$-0.8\% \leq \Delta W_0 - \Delta W_{24} \leq -0.001\% \ (3'').$$

When the difference between the weight reduction rates satisfies the above-mentioned formula (3') or (3"), the change in the composition of the thermal bonding sheet can be further reduced, and the stable formation of the sintered layer can be further promoted.

The thermal bonding sheet of the present embodiment contains no material whose weight is increased by heating, so that the difference between the weight reduction rate $\Delta W_0$ (%) and the weight reduction rate $\Delta W_{24}$ (%) (the difference between heating weight reduction rates) does not theoretically become a positive value. However, a precision balance is installed in a weight measuring apparatus, so that a slight environmental factor may cause the difference between the heating weight reduction rates to deviate to a positive value. In the present invention, in consideration of the case where the environmental factor of analysis causes a slight increase in a weight, the upper limit of the difference between the heating weight reduction rates is set to 0.5%. However, theoretically, the above formulae (3') and (3") are preferably satisfied.

(Precursor Layer that is to become Sintered Layer by Heating)

A material for forming the precursor layer 31 that is to become a sintered layer by heating is not particularly limited as long as it can become a sintered layer by heating.

The precursor layer 31 contains a thermally decomposable binder which is a solid at 23°C. When the precursor layer 31 contains the thermally decomposable binder, the shape of the sheet can easily be maintained before the thermal bonding step. During the thermal bonding step, thermal decomposition can easily proceed.

Herein, the term "solid" means that a viscosity at 23°C obtained by viscosity measurement in the following condition using a rheometer is more than 100,000 Pa-s.

<Viscosity Measurement Condition>

Rheometer: "MER III" manufactured by Thermo SCIENTFIC Inc.
Jig: Parallel Plate 20 mm φ
Gap: 100 μm
Shear Rate: 1/sec

In the present description, "thermally decomposable binder" means a binder that can be thermally decomposed in the thermal bonding step. It is preferred that the thermally decomposable binder little remains in the sintered layer (precursor layer 31 after heating) after the thermal bonding step. Examples of the thermally decomposable binder include materials having a carbon concentration obtained by the energy dispersive X-ray analysis after temperature rise from 23°C to 400°C at a temperature rising speed of 10°C/min under a nitrogen atmosphere of preferably 15% by weight or less even when it is contained in the precursor layer 31. For example, by employing a material that is easier to thermally decompose as the thermally decomposable binder, it is possible to make the thermally decomposable binder little remain in the sintered layer (precursor layer 31 after heating) after the thermal bonding step even if the content of the thermally decomposable binder is relatively large.

Examples of the thermally decomposable binder include polycarbonate, acryl resin, ethyl cellulose, and polyvinyl alcohol. These materials can be used solely or in combination of two or more. Among these, polycarbonate or acryl resin are used from the view point of high thermal decomposability.

While the polycarbonate is not particularly limited as far as it can thermally decompose in the thermal bonding step, examples of the polycarbonate include aliphatic polycarbonates that do not contain an aromatic compound (for example, benzene ring) between carbonate ester groups (-O-CO-O-) of the main chain, and are composed of an aliphatic chain, and aromatic polycarbonates that contain an aromatic compound between carbonate ester groups (-O-COO-) of the main chain. Among these, aliphatic polycarbonates are preferred.

Examples of the aliphatic polycarbonates include polyethylene carbonate, and polypropylene carbonate. Among these, polypropylene carbonate is preferred from the view point of solubility in an organic solvent in preparation of vanish for forming a sheet. The polycarbonate has a weight average molecular weight of preferably in the range of 10,000 to 1,000,000. The weight average molecular weight is a value obtained by measuring by GPC (gel permeation chromatography) and calculating with polystyrene conversion.

Examples of the aromatic polycarbonate include those containing a bisphenol A structure in the main chain.

The polycarbonate has a weight average molecular weight of preferably in the range of 10,000 to 1,000,000. The weight average molecular weight is a value obtained by measuring by GPC (gel permeation chromatography) and calculating with polystyrene conversion.

Examples of the acryl resin include polymers (acryl copolymers) composed of one or two or more esters of acrylic acid or methacrylic acid having a straight-chain or branched alkyl group having 30 or less carbons, particularly 4 to 18 carbons as far as they can thermally decompose in the thermal bonding step. Examples of the alkyl group include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, a undecyl group, a lauryl group, a tridecyl group, a tetradecyl group, a stearyl group, an octadecyl group, or a dodecyl group.

Examples of other monomer that forms a polymer (acryl copolymer) include, but are not limited to, carboxyl group-containing monomers such as acrylic acid, methacrylic acid, carboxyethyl acrylate, carboxypentyl acrylate, itaconic acid, maleic acid, fumaric acid or crotonic acid, acid anhydride monomers such as maleic anhydride or itaconic anhydride, hydroxyl group-containing monomers such as (meth)acrylate 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate or (4-hydroxymethylcyclohexyl)-methylacrylate, sulfonic group-containing monomers such as styrenesulfonic acid, allylsulfonic acid, 2-(meth)acrylamide-2-methylpropanesulfonic acid, (meth)acrylamide propanesulfonic acid, sulfopropyl (meth)acrylate or (meth)acryloyloxynaphthalenesulfonic acid, or phosphoric group-containing monomers such as 2-hydroxyethylacryloylphosphate.

Among the acryl resins, those having a weight average molecular weight of 10000 to 1000000 are more preferred, and those having a weight average molecular weight of 30000 to 700000 are further preferred. This is because those satisfying the numerical ranges described above are excellent in adhesion before the thermal bonding step, and in thermal decomposition during the thermal bonding step. The weight average molecular weight is a value that is measured by GPC (gel permeation chromatography) and calculated by conversion by polystyrene.

Among the acryl resin, acryl resins that thermally decompose at 200°C to 400°C are preferred.

The precursor layer contains the thermally decomposable binder which is a solid at 23°C and an organic component which is liquid at 23°C. When the precursor layer contains the organic component which is liquid at 23°C, a sheet shape is easily imparted, and the flexibility of the thermal bonding sheet can be enhanced to improve the adhesion between the thermal bonding sheet and an object to be bonded (semiconductor element, adherend or the like). The liquid organic component can be used in order to easily handle metallic fine particles (described later). Specifically, metallic fine particles can be dispersed in the liquid organic component to be used as a metallic fine particles-containing paste. In addition, the liquid organic component is also preferably contained in order to provide any adjusted mechanical properties.

Herein, the term "liquid" includes semiliquid. Specifically, it means that a viscosity at 23°C measured by viscosity measurement in the following condition using a rheometer is 100,000 Pa-s or less.

<Viscosity Measurement Condition>

Rheometer: "MER III" manufactured by Thermo SCIENTFIC Inc.
Jig: Parallel Plate 20 mm φ
Gap: 100 μm
Shear Rate: 1/sec

The liquid organic component at 23°C has vapor pressure at 20°C 0.1 Pa or less. The configuration can suppress the volatilization of the liquid organic component, and can consequently suppress the change in the composition of the thermal bonding sheet. Such an organic component is 1,6-hexanediol (vapor pressure: 0.007 Pa) and another example is isobornyl cyclohexanol (vapor pressure: 0.004 Pa).

The precursor layer 31 preferably includes metallic fine particles in the range of 60 to 98% by weight with respect to the entire precursor layer 31. The content of the metallic fine particles is more preferably in the range of 65 to 97% by weight, and further preferably in the range of 70 to 95% by weight. When metallic fine particles are contained in the range of 60 to 98% by weight, metallic fine particles can be sintered or melt to bond two objects (for example, a semiconductor chip and a lead frame).

Examples of the metallic fine particles include sinterable metallic particles.

Examples of the sinterable metallic particles include fine particles of metal. Examples of the metal include gold, silver, copper, silver oxide, and copper oxide. Among these, at least one selected from the group consisting of silver, copper, silver oxide, and copper oxide is preferred. When the metallic fine particles are at least one selected from the group consisting of silver, copper, silver oxide and copper oxide, the thermal bonding can be achieved more favorably.

The average particle size of the sinterable metallic particles is preferably 0.0005 μm or more, more preferably 0.001 μm or more. Examples of the lower limit of the average particle size include 0.01 μm, 0.05 μm, and 0.1 μm. On the other hand, the average particle size of the sinterable metallic particles is preferably 30 μm or less, more preferably 25 μm or less. Examples of the upper limit of the average particle size include 20 μm, 15 μm, 10 μm, and 5 μm.

The average diameter of crystallites of the sinterable metallic particles is preferably 0.01 nm or more and 60 nm or less, more preferably 0.1 nm or more and 50 nm or less, and still more preferably 0.5 nm or more and 45 nm or less. When the average diameter of the crystallites is in the above range, an excessive increase in the sintering temperature of the sinterable metallic particles can be suppressed.

The average particle size of the sinterable metallic particles is determined in the following method. To be more specific, the sinterable metallic particles are observed by SEM (scanning electron microscope) and an average particle size is determined. The SEM observation is preferably conducted with a 5000-fold magnification for the sinterable metallic particles of micro size, and with a 50000-fold magnification for the submicron-sized sinterable metallic particles, and with a 300000-fold magnification for the nano-sized sinterable metallic particles.

The shape of the sinterable metallic particles is not particularly limited, and is, for example, globular, bar-like, scaly, or indefinite.

The precursor layer 31 has a tensile modulus obtained by the following tensile testing method of preferably 10 MPa to 3000 MPa, more preferably 12 MPa to 2900 MPa, further preferably 15 MPa to 2500 MPa.

Tensile testing method:

(1) As a test sample, a thermal bonding sheet (thermal bonding sheet for tensile test) having a thickness of 200 $\mu$m, a width of 10 mm, and a length of 40 mm is prepared,
(2) a tensile test is conducted with a distance between chucks of 10 mm, a tensile speed of 50 mm/min, at 23°C, and
(3) the inclination of the linear part of the obtained stress-strain chart is determined as a tensile modulus.

When the tensile modulus of the precursor layer 31 is 10 MPa or more, it is possible to further prevent the material forming the thermal bonding sheet from protruding or climbing up on the chip surface at the time of die attachment. When the tensile modulus is 3000 MPa or less, it is possible to fix the semiconductor wafer, for example, at the time of dicing.

The precursor layer 31 has a carbon concentration obtained by the energy dispersive X-ray analysis after temperature rise from 23°C to 400°C at a heating rate of 10°C/min under a nitrogen atmosphere of preferably 15% by weight or less, more preferably 12% by weight or less, further preferably 10% by weight or less. When the carbon concentration is 15% by weight or less, almost no organic matter exists in the precursor layer 31 after temperature rise to 400°C. As a result, after the thermal bonding step, excellent heat resistance, and high reliability and heat characteristics even in high temperature environment are achieved.

The precursor layer 31 preferably has a peak at 150 to 350°C when subjected to differential thermal analysis from 23°C to 500°C in a nitrogen atmosphere at a temperature increase rate of 10°C/min, more preferably at 170 to 320°C, and still more preferably at 180 to 310°C. When the peak is present at 150 to 350°C, an organic matter (for example, a resin component constituting the precursor layer 31) can be said to be thermally decomposed in this temperature band. This provides more excellent heat resistance after the thermal bonding step.

The precursor layer 31 may contain, for example, a plasticizer as appropriate.

The thermal bonding sheets 3, 3' can be produced in an ordinary method. For example, a vanish containing aforementioned components for forming the precursor layer 31 is prepared, and the vanish is applied on a base separator to have a predetermined thickness to form an applied film, and then the applied film is dried to produce the thermal bonding sheets 3, 3'.

Preferred examples of the solvent used for the vanish include, but are not limited to, organic solvents and alcohol solvents capable of uniformly dissolving, kneading or dispersing the components. Examples of the organic solvents include ketone-based solvents such as dimethylformamide, dimethylacetamide, N-methylpyrrolidone, acetone, methylethylketone and cyclohexanone, toluene, and xylene. Examples of the alcohol solvents include ethylene glycol, diethylene glycol, 1,2-propanediol, 1,3-propanediol, 1,2-butanediol, 1,3-butanediol, 1,4-butanediol, 2-butene-1,4-diol, 1,2,6-hexanetriol, glycerin, octanediol, 2-methyl-2,4-pentanediol, and terpineol.

The applying method is not particularly limited. Examples of the method for applying a solvent include a die coater, a gravure coater, a roll coater, a reverse coater, a comma coater, a pipe doctor coater, and screen printing. Among these, a die coater is preferred from the view point of high uniformity of application thickness. The drying condition of the applied film is not particularly limited, and for example, the applied film can be dried, for example, at a drying temperature of 70 to 160°C for a drying time of 1 to 5 minutes. Even after drying the applied film, the solvent fails to entirely vaporize and remains in the coating film depending on the solvent.

As the base separator, polyethylene terephthalate (PET), polyethylene or polypropylene, a plastic film or paper having a surface coated with a release agent such as a fluorine-based release agent, a long-chain alkyl acrylate-based release agent can be used.

As the manufacturing method of the thermal bonding sheet 3, 3', for example, a method of mixing the components, and press-molding the obtained mixture to produce the thermal bonding sheet 3, 3' is also preferred. Examples of the mixer include a planetary mixer.

(Dicing tape)

The dicing tape 11 is formed by laminating the pressure-sensitive adhesive layer 2 on the base material 1.

The base material 1 is a base for the strength of the thermal bonding sheet with dicing tape 10, 12, and is preferably ultraviolet transmissive. Examples of the base material 1 include polyolefin such as low-density polyethylene, straight chain polyethylene, intermediate-density polyethylene, high-density polyethylene, very low-density polyethylene, random copolymer polypropylene, block copolymer polypropylene, homopolypropylene, polybutene, and polymethylpentene; an ethylene-vinylacetate copolymer; an ionomer resin; an ethylene(meth)acrylic acid copolymer; an ethylene(meth)acrylic acid ester (random or alternating) copolymer; an ethylene-butene copolymer; an ethylene-hexene copolymer; polyurethane; polyester such as polyethyleneterephthalate and polyethylenenaphthalate; polycarbonate; polyetheretherketone; polyetherimide; polyamide; whole aromatic polyamides; polyphenylsulfide; aramid (paper); glass; glass cloth; a fluorine resin; polyvinyl chloride; polyvinylidene chloride; a cellulose resin; a silicone resin; metal (foil); and paper.

Further, the material of the base material 1 includes a polymer such as a cross-linked body of the above resins. The above plastic film may be also used as unstreched, or may be also used on which a monoaxial or a biaxial stretching treatment is performed depending on necessity. According to resin sheets in which heat shrinkable properties are given by the stretching treatment, etc., the adhesive area of the pressure sensitive adhesive layer 2 and the thermal bonding sheet 3, 3' is reduced by thermally shrinking the base material 1 after dicing, and the recovery of the semiconductor chips can be facilitated.

A known surface treatment such as a chemical or physical treatment such as a chromate treatment, ozone exposure, flame exposure, high voltage electric exposure, and an ionized radiation treatment, and a coating treatment by an undercoating agent (for example, a tacky substance described later) can be performed on the surface of the base material 1 in order to improve adhesiveness, holding properties, etc. with the adjacent layer.

The thickness of the base material 1 can be appropriately decided without limitation particularly. However, it is generally about 5 to 200 $\mu$m, preferably 10 $\mu$m to 150 $\mu$m, more preferably 15 $\mu$m to 100 $\mu$m.

Examples of the pressure-sensitive adhesive layer 2 include, but are not limited to, common pressure-sensitive adhesives such as an acryl-based pressure-sensitive adhesive or a rubber-based pressure-sensitive adhesive. An acrylic pressure-sensitive adhesive having an acrylic polymer as a base polymer is preferable as the pressure-sensitive adhesive from the point of view of clean washing properties of an electric part such as a semiconductor wafer and glass that dislike contamination with ultra pure water and an organic solvent such as alcohol.

Examples of the acrylic polymer include acrylic polymers each comprising, as one or more monomer components, one or more selected from alkyl esters of (meth)acrylic acid (for example, linear and branched alkyl esters thereof each having an alkyl group having 1 to 30 carbon atoms, in particular, 4 to 18 carbon atoms, such as methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, tridecyl ester, tetradecyl ester, hexadecyl ester, octadecyl ester, and eicosyl ester thereof) and cycloalkyl esters of (meth)acrylic acid (for example, cyclopentyl ester and cyclohexyl ester thereof). The wording "esters of (meth)acrylic acid" means esters of acrylic acid and/or methacrylic acid. All of the words including "(meth)" in connection with the present invention have an equivalent meaning.

The acrylic polymer may optionally contain a unit corresponding to a different monomer component copolymerizable with the above-mentioned alkyl ester of (meth)acrylic acid or cycloalkyl ester thereof in order to improve the cohesive force, heat resistance or some other property of the polymer. Examples of such a monomer component include carboxyl-containing monomers such as acrylic acid, methacrylic acid, carboxyethyl (meth)acrylate, carboxypentyl (meth)acrylate, itaconic acid, maleic acid, fumaric acid, and crotonic acid; acid anhydride monomers such as maleic anhydride, and itaconic anhydride; hydroxyl-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxylmethylcyclohexyl)methyl (meth)acrylate; sulfonic acid group containing monomers such as styrenesulfonic acid, allylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid; phosphoric acid group containing monomers such as 2-hydroxyethylacryloyl phosphate; acrylamide; and acrylonitrile. These copolymerizable monomer components may be used alone or in combination of two or more thereof. The amount of the copolymerizable monomer(s) to be used is preferably 40% or less by weight of all the monomer components.

For crosslinking, the acrylic polymer can also contain multifunctional monomers as the copolymerizable monomer component if necessary. Such multifunctional monomers include hexane diol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylol propane tri(meth)acrylate, pentaerythritol tri(meth)acrylate, dipentaerythritol hexa(meth)acrylate, epoxy (meth)acrylate, polyester (meth)acrylate, urethane (meth)acrylate etc. These multifunctional monomers can also be used as a mixture of one or more thereof. From the viewpoint of adhesiveness etc., the use amount of the multifunctional monomer is preferably 30 wt% or less based on the whole monomer components.

The acrylic polymer can be obtained by polymerizing a single monomer or a mixture of monomers of two types or more. The polymerization can be performed with any of polymerization methods such as solution polymerization, emulsification polymerization, bulk polymerization, and suspension polymerization. The content of a low molecular weight material is preferably small from the point of view of prevention of contamination to a clean adherend. In this respect, the number average molecular weight of the acrylic polymer is preferably about 100,000 or more, and more preferably about 200,000 to 3,000,000, and especially preferably about 300,000 to 1,000,000.

Further, an external crosslinking agent can be suitably adopted to the pressure-sensitive adhesive in order to increase the number average molecular weight of an acrylic polymer that is a base polymer, etc. Specific examples of the external crosslinking method include methods of reacting by adding a so-called crosslinking agents such as a polyisocyanate compound, an epoxy compound, an aziridine compound, and a melamine based crosslinking agent. When the external crosslinking agent is used, the amount to be used can be suitably determined by the balance with the base polymer that is to be crosslinked and by the purpose of use as a pressure-sensitive adhesive. In general, it is preferably mixed at about 5 parts by weight or less, and more preferably 0.1 to 5 parts by weight to 100 parts by weight of the base polymer. Besides the above-described components, an additive such as conventionally known various tackifiers and antioxidants may be used in the pressure-sensitive adhesive depending on necessity.

The pressure sensitive adhesive layer 2 is constituted by containing a radiation curable pressure sensitive adhesive. The radiation curable pressure sensitive adhesive can easily decrease its adhesive strength by increasing the degree of crosslinking by irradiation with radiation such as ultraviolet-ray. By radiating only a part 2a corresponding to the work attaching part of the pressure sensitive adhesive layer 2 shown in Fig. 2, a difference of the adhesive strength to another part 2b can be also provided.

Also, by curing the radiation curable pressure-sensitive adhesive layer 2 together with the thermal bonding sheet 3' shown in Fig. 2, the part 2a where the adhesive strength is significantly reduced can be easily formed. Since the thermal bonding sheet 3' is attached to the part 2a that has been cured and has reduced adhesive strength, the boundary in the pressure-sensitive adhesive layer 2 between the part 2a and the thermal bonding sheet 3' has the property of easily peeling off at the time of pickup. On the other hand, the part that has not been irradiated with radiation has sufficient adhesive strength, and forms the part 2b. Irradiation of the pressure-sensitive adhesive layer can be conducted after dicing and before pickup.

As described above, in the pressure-sensitive adhesive layer 2 of the thermal bonding sheet with dicing tape 10 shown in Fig. 1, the part 2b formed of the uncured radiation curable pressure-sensitive adhesive adheres to the thermal bonding sheet 3, and the holding force at the time of dicing can be secured. In such a way, the radiation curable pressure-sensitive adhesive can support the thermal bonding sheet 3 for fixing the chip-like work (e.g., semiconductor chip) onto an adherend such as a substrate with good balance of adhesion and peeling. In the pressure-sensitive adhesive layer 2 of the thermal bonding sheet with dicing tape 11 shown in Fig. 2, the part 2b can fix the wafer ring.

A radiation curable pressure-sensitive adhesive having a radiation curable functional group such as a carbon-carbon double bond and having adherability can be used without special limitation. Example of the radiation curable pressure-sensitive adhesive include an additive-type radiation curable pressure-sensitive adhesive in which a radiation curable monomer component or oligomer component is mixed into a general pressure-sensitive adhesive such as an acrylic pressure-sensitive adhesive or a rubber-based pressure-sensitive adhesive.

The radiation-curing monomer component to be compounded includes, for example, urethane oligomer, urethane (meth)acrylate, trimethylol propane tri(meth)acrylate, tetramethylol methane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butane diol di(meth)acrylate. The radiation-curing oligomer component includes various acrylate oligomers such as those based on urethane, polyether, polyester, polycarbonate, polybutadiene etc., and their molecular weight is preferably in the range of about 100 to 30000. For the compounded amount of the radiation-curable monomer component or oligomer component, the amount of which the adhesive strength of the pressure-sensitive adhesive layer can be decreased can be determined appropriately depending on the type of the above-described pressure-sensitive adhesive layer. In general, the compounded amount is, for example, 5 to 500 parts by weight, and preferably about 40 to 150 parts by weight relative to 100 parts by weight of the base polymer such as an acrylic polymer constituting the pressure-sensitive adhesive.

Besides the additive-type radiation curable pressure-sensitive adhesive that is explained above, examples of the radiation curable pressure-sensitive adhesive include an internal radiation curable pressure-sensitive adhesive in which a polymer having a carbon-carbon double bond in the polymer side chain, in the main chain, or in the ends of the main chain is used as the base polymer. The internal radiation curable pressure-sensitive adhesive does not have to contain an oligomer component that is a low molecular component, etc., or it does not contain much of the component. Therefore, it is preferable because a pressure-sensitive adhesive layer having a stable layer structure can be formed without the oligomer component, etc. shifting in the pressure-sensitive adhesive with the passage of time.

A base polymer having a carbon-carbon double bond and having adherability can be used without limitation. As such base polymer, a polymer having an acrylic polymer as a basic skeleton is preferable. Examples of the basic skeleton of the acrylic polymer include the acrylic polymers shown above.

A method of introducing a carbon-carbon double bond into the acrylic polymer is not especially limited, and various methods can be adopted. However, a molecular design is easy when the carbon-carbon double bond is introduced in the polymer side chain. For example, a method of copolymerizing a monomer having a functional group with an acrylic polymer and then performing condensation or an addition reaction on a compound having a functional group that can react with the functional group of the monomer and having a carbon-carbon double bond while maintaining the radiation curing property of a carbon-carbon double bond.

Examples of the combination of these functional groups include a carboxylic acid group and an epoxy group, a carboxylic acid group and an aziridyl group, and a hydroxyl group and an isocyanate group. Among these combinations of the functional group, the combination of a hydroxyl group and an isocyanate group is preferable because of ease of pursuing the reaction. Further, the functional group may be in any side of the acrylic polymer and the above-describe compounds as long as these functional groups are combined to produce the acrylic polymer having a carbon-carbon double bond. However, the case where the acrylic polymer has a hydroxyl group and the above-described compound has an isocyanate group is preferable in the above-described preferable combination. In this case, examples of the isocyanate compound having a carbon-carbon double bond include methacryloylisocyanate, 2-methacryloyloxyethyl-isocyanate, and m-isopropenyl-$\alpha,\alpha$-dimethylbenzylisocyanate. Further, a polymer in which the hydroxyl group containing the monomers exemplified above and an ether based compound of 2-hydroxyethylvinylether, 4-hydroxybutylvinylether, diethylene glycol monovinylether, etc. are copolymerized can be used as the acrylic polymer.

A base polymer having a carbon-carbon double bond (especially, acrylic polymer) can be used alone as the internal-type radiation curable pressure-sensitive adhesive. However, the above-described radiation curable monomer component or oligomer component can be mixed to an extent that its characteristics do not deteriorate. The amount of the radiation curable oligomer component, etc. is normally within 30 parts by weight and preferably in the range of 0 to 10 parts by weight to 100 parts by weight of the base polymer.

A photopolymerization initiator is contained in the internal radiation curable pressure sensitive adhesive in the case of curing with radiation such as ultraviolet rays. Examples of the photopolymerization initiator include an $\alpha$-ketol based compound such as 4-(2-hydroxyethoxy)phenyl(2-hydroxy-2-propyl)ketone, $\alpha$-hydroxy-$\alpha,\alpha$'-dimethylacetophenone, 2-methyl-2-hydroxypropyophenone, and 1-hydroxycyclohexylphenylketone; an acetophenone based compound such as methoxyacetophenone, 2,2-dimethoxy-2-phenylcetophenone, 2,2-diethoxyacetophenone, and 2-methyl-1-[4-(methylthio)-phenyl]-2-morpholinopropane-1-one; a benzoinether based compound such as benzoinethylether, benzoinisopropylether, and anisoinmethylether; a ketal based compound such as benzyldimethylketal; an aromatic sulfonylchloride based compound such as 2-naphthalenesulfonylchloride; a photoactive oxime based compound such as 1-phenone-1,1-propanedion-2-(o-ethoxycarbonyl)oxime; a benzophenone based compound such as benzophenone, benzoylbenzoic acid and 3,3'-dimethyl-4-methoxybenzophenone; a thioxanthone based compound such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketone; acylphosphinoxide; acylphosphonate and the like. The compounding amount of the photopolymerization initiator is about 0.05 to 20 parts by weight for example based on 100 parts by weight of the base polymer such as an acryl polymer constituting the pressure sensitive adhesive.

Further, examples of the radiation curable pressure sensitive adhesive include a rubber based pressure sensitive adhesive and acryl-based pressure sensitive adhesive containing an addition polyerizable compound having two or more unsaturated bonds, a photopolymerizable compound such as alkoxysilane having an epoxy group, and a photopolymerization initiator such as a carbonyl compound, an organic sulfur compound, a peroxide, an amine salt-based and an onium salt based compound, which are disclosed in JP-A No. 60-196956.

The radiation curable pressure-sensitive adhesive layer 2 can contain a compound that colors by irradiation as necessary. By containing the compound that colors by irradiation in the pressure-sensitive adhesive layer 2, only the part that is irradiated with radiation can be colored. In other words, the part 2a corresponding to a work attaching part 3a shown in Fig. 1 can be colored. Therefore, it is possible to rapidly determine whether the pressure-sensitive adhesive layer 2 is irradiated with radiation by visual inspection, and the work attaching part 3a is easy to recognize, and bonding of the work is easy. In detecting a semiconductor chip by an optical sensor or the like, the detection accuracy is improved, and a malfunction does not occur at the time of pickup of the semiconductor chip. The compound that colors by irradiation is a compound that is colorless or light-colored before irradiation, but becomes colored by irradiation, and, for example, a leuco dye can be recited. The use rate of the compound that colors by irradiation can be set appropriately.

The thickness of the pressure sensitive adhesive layer 2 is not particularly limited. However, it is preferably about 1 to 50 $\mu$m from the viewpoints of compatibility of chipping prevention of the chip cut face and holding the fixation of the adhesive layer, etc. It is preferably 2 to 30 $\mu$m, and further preferably 5 to 25 $\mu$m.

The dicing tape 11 according to the present embodiment is manufactured for example as follows.

First, the base material 1 can be formed with a conventionally known film forming method. Examples of the film forming method include a calendar film forming method, a casting method in an organic solvent, an inflation extrusion method in a closed system, a T die extrusion method, a coextrusion method, and a dry lamination method.

Next, the pressure-sensitive adhesive layer can be formed by coating a pressure-sensitive adhesive composition solution onto a base material to form a coating film, and then drying the coating film under prescribed conditions (and heat-crosslinking depending on necessity). The coating method is not especially limited, and examples thereof include roll coating, screen coating, and gravure coating. As the drying condition, drying is conducted, for example, at a drying temperature of 80 to 150°C for a drying time of 0.5 to 5 minutes. After forming an applied film by applying a pressure-sensitive adhesive composition on a separator, the applied film may be dried in the above drying condition to form the pressure-sensitive adhesive layer 2. Thereafter, the pressure-sensitive adhesive layer 2 is bonded on the base material 1 together with the separator. In this manner, the dicing tape 11 is prepared.

The thermal bonding sheet with dicing tape 10, 12 can be produced in an ordinary method. For example, by bonding the pressure-sensitive adhesive layer 2 of the dicing tape 11 and the thermal bonding sheet 3, it is possible to produce the thermal bonding sheet with dicing tape 10.

In the thermal bonding sheet with dicing tape 10, it is preferred that the thermal bonding sheet 3 is covered with a separator. In one exemplary method, after bonding the dicing tape 11 and the thermal bonding sheet 3, the base separator that is laminated on the thermal bonding sheet 3 is peeled off, and on an exposed surface of the thermal bonding sheet 3 in the thermal bonding sheet with dicing tape 10 after peeling off the base separator, a separator is attached. In other words, it is preferred that the dicing tape 11, the thermal bonding sheet 3, and the separator are laminated in this sequence.

In the above embodiment, the thermal bonding sheet with dicing tape in which the dicing tape and the thermal bonding sheet are laminated was described. However, the thermal bonding sheet of the present invention may be provided in the state that it is not bonded with the dicing tape.

The thermal bonding sheet is preferably a thermal bonding sheet with both-side separators, which is sandwiched between two separators in the form where the dicing tape is not bonded. That is, a thermal bonding sheet with both-side separators in which the first separator, the thermal bonding sheet, and the second separator are laminated in this sequence is preferred.

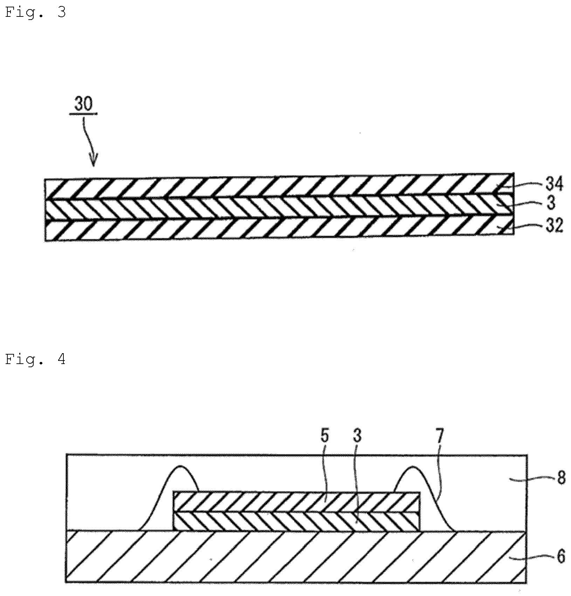

Fig. 3 is a cross-sectional schematic view showing one embodiment of the thermal bonding sheet with both-side separators.

A thermal bonding sheet with both-side separators 30 shown in Fig. 3 has such a structure that a first separator 32, the thermal bonding sheet 3, and a second separator 34 are laminated in this sequence. As the first separator 32, and the second separator 34, the one that is identical to the base separator can be used.

The thermal bonding sheet may be in such a form that a separator is laminated on only one surface of the thermal bonding sheet in the form where the dicing tape is not bonded.

(Method of manufacturing semiconductor device)

A method of manufacturing a semiconductor device according to the present embodiment includes:

a step of preparing the thermal bonding sheet, and
a thermal bonding step of thermally bonding a semiconductor chip on an adherend via the thermal bonding sheet (hereinafter, also referred to as the first manufacturing method).

The method of manufacturing a semiconductor device according to the present embodiment also includes:

a step of preparing the thermal bonding sheet with dicing tape,
a bonding step of bonding the thermal bonding sheet of the thermal bonding sheet with dicing tape, and a back surface of a semiconductor wafer,
a dicing step of dicing the semiconductor wafer together with the thermal bonding sheet to form a chip-like semiconductor chip,
a pickup step of picking up the semiconductor chip together with the thermal bonding sheet from the thermal bonding sheet with dicing tape, and
a thermal bonding step of thermally bonding the semiconductor chip onto the adherend via the thermal bonding sheet (hereinafter, also referred to as the second manufacturing method).

The method of manufacturing a semiconductor device according to the first manufacturing method is different from the method of manufacturing a semiconductor device according to the second manufacturing method in that the thermal bonding sheet is used alone, as compared with the method of manufacturing a semiconductor device according to the second manufacturing method where the thermal bonding sheet with dicing tape is used, and these methods are common in other points. In the method of manufacturing a semiconductor device according to the first manufacturing method, after preparing the thermal bonding sheet, the step of bonding the thermal bonding sheet with the dicing tape is conducted, and the subsequent steps can be conducted in the same manner as the method of manufacturing a semiconductor device according to the second manufacturing method. Hereinafter, the method of manufacturing a semiconductor device according to the second manufacturing method is described.

In the method of manufacturing a semiconductor device, the thermal bonding sheet with dicing tape 10, 12 is prepared (preparing step). The separator that is optionally provided onto the thermal bonding sheet 3, 3' is appropriately peeled off, and the dicing thermal bonding sheet 10, 11 of the present invention is used as follows. The manufacturing method is explained below referring to Fig. 3 using the case of the thermal bonding sheet with dicing tape 10 as an example.

First, a semiconductor wafer 4 is fixed onto the semiconductor attaching part 3a of the thermal bonding sheet 3 in the thermal bonding sheet with dicing tape 10 by press-bonding and by adhering and holding (mounting step). The present step is performed while pressing with a pressing means such as a press-bonding roll. A temperature upon mounting is not particularly limited, and is preferably in the range of 23 to 90°C.

As a semiconductor wafer 4, the one in which an electrode pad is formed on one side, and a silver thin film is preferably formed on the outermost surface of the other side (hereinafter, also referred to as backside) is preferred. In addition, on the outermost surface of the backside of the semiconductor wafer 4, it is preferable to form a thin film containing the same kind of metal as the sinterable metallic fine particles included in the precursor layer 31. The thickness of the silver thin film can be, for example, 10 nm to 1000 nm. Between the semiconductor wafer 4 and the silver thin film, a titanium thin film may further be formed. The thickness of the titanium thin film can be, for example, 10 nm to 1000 nm. When the silver thin film is formed, it is possible to thermally bond a semiconductor chip 5 and the thermal bonding sheet 3 firmly in the later-described thermal bonding step. Also, when the titanium thin film is formed, the reliability of the electrode is improved. The silver thin film, and the titanium thin film can be formed, for example, by vapor deposition.

Next, dicing of the semiconductor wafer 4 is performed (dicing step). With this operation, a semiconductor chip 5 is formed by cutting the semiconductor wafer 4 into a prescribed size to make it into individual pieces. The dicing method is not particularly limited, but is performed following an ordinary method from the circuit face side of the semiconductor wafer 4, for example. Further, a cutting method, so-called full cut, in which cutting-in is performed to the thermal bonding sheet with dicing tape 10, can be adopted in the present step, for example. The dicing apparatus that is used in the present step is not especially limited, and a conventionally known apparatus can be used. Further, because the semiconductor wafer 4 is adhered and fixed by the thermal bonding sheet with dicing tape 10, chip breakage and chip fly can be suppressed, and at the same time, damage of the semiconductor wafer 4 can be suppressed.

Picking up of the semiconductor chip 5 is performed to peel off the semiconductor chip that is adhered and fixed to the thermal bonding sheet with dicing tape 10 (pickup step). The method of picking up is not especially limited, and various conventionally known methods can be adopted. Examples thereof include a method of pushing up an individual semiconductor chip 5 from the thermal bonding sheet with dicing tape 10 side using a needle and picking up the semiconductor chip 5 that is pushed up with a picking up apparatus.

As the pickup condition, a needle pushing up rate is preferably 5 to 100 mm/sec., more preferably 5 to 10 mm/sec. in terms of prevention of chipping.

Here, the pickup is performed after irradiating the pressure-sensitive adhesive layer 2 with the ultraviolet ray if the pressure-sensitive adhesive layer 2 is of a radiation curable. With this operation, the adhesive strength of the pressure-sensitive adhesive layer 2 to the thermal bonding sheet 3 decreases, and the semiconductor chip 5 is easily peeled off. As a result, the pickup becomes possible without damaging the semiconductor chip. The conditions during ultraviolet ray irradiation such as the radiation strength and the radiation time are not especially limited, and may be appropriately set as necessary. Any known light source for irradiation with ultraviolet ray can be used. When the pressure-sensitive adhesive layer is cured in advance by irradiating with ultraviolet rays, and the cured pressure-sensitive adhesive layer and the thermal bonding sheet are bonded, the irradiation with ultraviolet rays here is not required.

Then, the picked semiconductor chip 5 is die attached (thermally bonded) to an adherend 6 via the thermal bonding sheet 3 (thermal bonding step). Examples of the adherend 6 include a lead frame, a TAB film, a substrate, and a semiconductor chip that is separately produced. The adherend 6 may be a deformable adherend that can be deformed easily or may be a non-deformable adherend such as a semiconductor wafer that is difficult to be deformed.

Metal lead frames such as a Cu lead frame and a 42 Alloy lead frame can be used as the lead frame. As the substrate, a conventionally known one can be used. An organic substrate made of glass epoxy, BT (Bismaleimide-Triazine), polyimide, and the like can be exemplified. Among these, by using a metal lead frame, it is possible to integrate with the metallic fine particles by thermal bonding. As the substrate, an insulating circuit substrate in which a coper circuit board is laminated on an insulating board such as a ceramic plate can be recited. By using an insulating circuit substrate, it is possible to produce, for example, a power semiconductor device that controls or supplies electric power.

In the thermal bonding step, metallic fine particles are sintered by heating, and a thermally decomposable binder is thermally decomposed as necessary. Also, residual liquid organic components that have not completely volatilized in the drying step are caused to be volatilized. The heating temperature can be preferably 180 to 400°C, more preferably 190 to 370°C, further preferably 200 to 350°C. The heating time can be preferably 0.3 to 300 minutes, more preferably 0.5 to 240 minutes, further preferably 1 to 180 minutes. The thermal bonding may be conducted under a pressurized condition. The pressurizing condition is preferably within the range of 1 to 500 kg/cm$^2$, more preferably within the range of 5 to 400 kg/cm$^2$. The thermal bonding under a pressurized condition can be carried out by an apparatus capable of conducting heating and pressurizing simultaneously such as flip chip bonder, for example. Parallel plate pressing is also applicable.

Next, if necessary, as depicted in Fig. 4, the tip of a terminal part (inner lead) of the adherend 6 is electrically connected to an electrode pad (not shown in the figures) on the semiconductor chip 5 with a bonding wire 7 (wire bonding step). Examples of the bonding wire 7 that can be used include a gold wire, an aluminum wire, and a copper wire. The temperature when performing the wire bonding is in the range of 23 to 300°C and preferably in the range of 23 to 250°C. The heating time is a few seconds to a few minutes. The connection is in a heated state so that the temperature becomes in the above-described range, and it is performed using both the vibration energy due to ultrasonic waves and the compression energy due to the applied pressure.

Further, if necessary, the semiconductor chip 5 is sealed with a sealing resin 8 as shown in Fig. 4 (sealing step). The present step is performed to protect the semiconductor chip 5 and the bonding wire 7 that are mounted on the adherend 6. The present step is performed by molding a resin for sealing with a mold. Example of the sealing resin 8 that is used include epoxy resins. The resin sealing is performed normally at a heating temperature of 175°C for 60 to 90 seconds. However, the present invention is not limited to this and it can be performed by curing at 165 to 185°C for a few minutes for example. With this, the sealing resin 8 is cured. In the present sealing step, a method of embedding the semiconductor chip 5 into a sheet-like sealing sheet (see, JP-A 2013-7028, for example) can also be employed. Besides the molding of a sealing resin by a die, a gel sealing type in which silicone gel is poured into a case type container is also applicable.

The sealing resin 8 that is not sufficiently cured in the sealing step is cured completely by heating (post curing step). The heating temperature in the present step differs depending on the type of the sealing resin. However, it is in the range of 165 to 185°C for example, and the heating time is about 0.5 to 8 hours.

The thermal bonding sheet, and the thermal bonding sheet with dicing tape according to the present invention can be favorably used in laminating a plurality of semiconductor chips to achieve three-dimensionally mounting. At this time, a thermal bonding sheet and a spacer may be laminated between semiconductor chips, or not a spacer but only a thermal bonding sheet may be laminated between semiconductor chips, and these can be appropriately changed depending on the manufacturing condition, use application and the like.

Also, the thermal bonding sheet, and the thermal bonding sheet with dicing tape of the present invention can be used for thermally bonding two objects without limited to the application exemplified above.

EXAMPLES

Hereinafter, the present invention will be specifically described by Examples.

<Example 1>

100 parts by weight of copper particles manufactured by Mitsui Mining and Smelting Co., Ltd. and having an average particle size of 200 nm and an average diameter of crystallites of 31 nm as copper fine particles, 14 parts by weight of an acrylic resin ("MM-2002-1" (solid at 23°C) manufactured by Fujikura Kasei Co., Ltd.) as a thermally decomposable binder B, 9 parts by weight of 1,6-hexanediol (manufactured by Tokyo Chemical Industry Co., Ltd.) as a liquid organic component A, and 30 parts by weight of a solvent (methyl ethyl ketone) were charged into a stirring container, and stirred and mixed using a hybrid mixer ("HM-500" manufactured by Keyence Corporation) in a stirring mode for 3 minutes. The obtained varnish was coated on a release-treated film ("MRA 50" manufactured by Mitsubishi Plastics, Inc.), and the coating film was dried at 110°C for 3 minutes to obtain a thermal bonding sheet having a thickness of 40 μm.

<Example 2>

100 parts by weight of copper particles manufactured by Mitsui Mining and Smelting Co., Ltd. and having an average particle size of 200 nm and an average diameter of crystallites of 31 nm as copper fine particles, 14 parts by weight of a polypropylene carbonate resin ("QPAC 40" manufactured by Empower, (solid at 23°C)) as a thermally decomposable binder A, 9 parts by weight of 1,6-hexanediol (manufactured by Tokyo Chemical Industry Co., Ltd.) as a liquid organic component A, and 30 parts by weight of a solvent (methyl ethyl ketone) were charged into a stirring container, and stirred and mixed using a hybrid mixer ("HM-500" manufactured by Keyence Corporation) in a stirring mode for 3 minutes. The obtained varnish was coated on a release-treated film ("MRA 50" manufactured by Mitsubishi Plastics, Inc.), and the coating film was dried at 150°C for 5 minutes to obtain a thermal bonding sheet having a thickness of 40 $\mu$m.

<Reference example 3>

100 parts by weight of copper particles manufactured by Mitsui Mining and Smelting Co., Ltd. and having an average particle size of 200 nm and an average diameter of crystallites of 31 nm as copper fine particles, 14 parts by weight of an acrylic resin ("MM-2002-1" (solid at 23°C) manufactured by Fujikura Kasei Co., Ltd.) as a thermally decomposable binder B, 9 parts by weight of isobornyl cyclohexanol ("Tersorb MTPH" manufactured by Nippon Terpene Chemicals, Inc.) as a liquid organic component B, and 30 parts by weight of a solvent (methyl ethyl ketone) were charged into a stirring container, and stirred and mixed using a hybrid mixer ("HM-500" manufactured by Keyence Corporation) in a stirring mode for 3 minutes. The obtained varnish was coated on a release-treated film ("MRA 50" manufactured by Mitsubishi Plastics, Inc.), and the coating film was dried at 150°C for 5 minutes to obtain a thermal bonding sheet having a thickness of 40 $\mu$m.

<Reference example 4>

100 parts by weight of copper particles manufactured by Mitsui Mining and Smelting Co., Ltd. and having an average particle size of 200 nm and an average diameter of crystallites of 31 nm as copper fine particles, 14 parts by weight of a polypropylene carbonate resin ("QPAC 40" manufactured by Empower (solid at 23°C)) as a thermally decomposable binder A, 9 parts by weight of isobornyl cyclohexanol ("Tersorb MTPH" manufactured by Nippon Terpene Chemicals, Inc.) as a liquid organic component B, and 30 parts by weight of a solvent (methyl ethyl ketone) were charged into a stirring container, and stirred and mixed using a hybrid mixer ("HM-500" manufactured by Keyence Corporation) in a stirring mode for 3 minutes. The obtained varnish was coated on a release-treated film ("MRA 50" manufactured by Mitsubishi Plastics, Inc.), and the coating film was dried at 110°C for 3 minutes to obtain a thermal bonding sheet having a thickness of 40 $\mu$m.

<Comparative Example 1>

A paste containing metallic fine particles (silver fine particles) ("NPS-HB" manufactured by Harima Chemicals, Inc.) was used as it was.

<Evaluation>

With respect to the following items, samples of Examples and Comparative Examples were evaluated. The results are shown in Table 1.

(Measurement of Difference between Heating Weight Reduction Rates of Thermal Bonding Sheet)

From the produced thermal bonding sheet, about 10 mg of a sample was cut out in a size of 5 mm $\times$ 5 mm to prepare a measurement sample. A measurement sample before being exposed to an atmosphere having a temperature of 23 $\pm$ 2°C and a humidity of 50 $\pm$ 20% was analyzed in a nitrogen atmosphere at a temperature of from 23°C to 400°C at a temperature increase rate of 10°C/min by using a differential thermal balance ("TG-DTA TG 8120" manufactured by Rigaku Corporation) to obtain a weight loss curve. A value $W_{23}$ at 23°C and a value $W_{400}$ at 400°C were read, and a weight reduction rate $\Delta W_0$ (%) before exposure was determined according to the following formula (1).

$$\Delta W_0 = \{ (W_{400} - W_{23})/W_{23} \} \times 100 \ (\%) \ (1)$$

wherein
$W_{23}$ is a weight of the thermal bonding sheet at 23°C before the thermal bonding sheet is exposed to the atmosphere; and $W_{400}$ is a weight of the thermal bonding sheet at 400°C before the thermal bonding sheet is exposed to the atmosphere.
A new measurement sample was cut out in the same procedure as above, and exposed to an atmosphere having a temperature of 23 $\pm$ 2°C and a humidity of 50 $\pm$ 20% for 24 hours. The measurement sample after being exposed was analyzed in a nitrogen atmosphere at a temperature of from 23°C to 400°C at a temperature increase rate of 10°C/min by using a differential thermal balance ("TG-DTA TG 8120" manufactured by Rigaku Corporation) to obtain a weight loss curve. A value $W'_{23}$ at 23°C and a value $W'_{400}$ at 400°C were read, and a weight reduction rate $\Delta W_{24}$ (%)

after exposure for 24 hours was determined according to the following formula (2).

$$\Delta W_{24} = \{(W'_{400} - W'_{23})/W'_{23}\} \times 100 \ (\%) \ (2)$$

wherein
$W'_{23}$ is a weight of the thermal bonding sheet at 23°C after the thermal bonding sheet is exposed to the atmosphere;
and $W'_{400}$ is a weight of the thermal bonding sheet at 400°C after the thermal bonding sheet is exposed to the atmosphere.
A difference ($\Delta W_0$ - $\Delta W_{24}$) between the weight reduction rates before and after exposure was calculated. When the difference was within the range of -1% to 0.5%, the difference was evaluated as "O". When the difference was smaller than -1%, the difference was evaluated as "×".

(Measurement of Difference between Heating Weight Reduction Rates of Metallic fine particles-Containing Paste)

The measurement and the evaluation were performed in the same manner as in the measurement of the difference between the heating weight reduction rates of the thermal bonding sheet except that a coating solution film was used, which was obtained by applying a metallic fine particles-containing paste as a measurement sample in a thickness of 40 $\mu$m onto a release-treated film ("MRA 50" manufactured by Mitsubishi Plastics, Inc.).

[Table 1]

| | | Example 1 | Example 2 | Example 3 | Example 4 | Comparative Example 1 |
|---|---|---|---|---|---|---|
| Copper fine particles A (parts by weight) | Copper fine particles having average particle size of 200 nm | 100 | 100 | 100 | 100 | - |
| Metallic fine particles-containing paste A (parts by weight) | NPS-HB | - | - | - | - | 100 |
| Thermally decomposable binder A (parts by weight) | QPAC40 | - | 14 | - | 14 | - |
| Thermally decomposable binder B (parts by weight) | MM-2002-1 | 14 | - | 14 | - | - |
| Liquid organic component A (parts by weight) | 1,6-hexanediol | 9 | 9 | - | - | - |
| Liquid organic component B (parts by weight) | Isobornyl cyclohexanol | | - | 9 | 9 | - |
| Organic solvent A (parts by weight) | Methyl ethyl ketone | 30 | 30 | 30 | 30 | - |
| Drying condition of coating film | Temperature | 110°C | 150°C | 150°C | 110°C | - |
| | time | 3 minutes | 5 minutes | 5 minutes | 3 minutes | - |
| Weight reduction rate at 23°C to 400°C before exposure $\Delta W_0$ (%) | | -18.7 | -18.7 | -18.7 | -18.7 | -14.1 |
| Weight reduction rate at 23°C to 400°C after exposure $\Delta W_{24}$ (%) | | -18.6 | -18.7 | -18.6 | -18.7 | -12 |

(continued)

|  | Example 1 | Example 2 | Example 3 | Example 4 | Comparative Example 1 |
|---|---|---|---|---|---|
| Difference between weight reduction rates before and after exposure $\Delta W_0$-$\Delta W_{24}$ (%) | -0.1 | 0 | -0.1 | 0 | -2.1 |

In Examples 1 to 4, the difference between the heating weight reduction rates before and after exposure was suppressed. Meanwhile, in Comparative Example 1, the difference between the heating weight reduction rates before and after exposure was large. This is considered to be by the influence of the volatilization of the dispersion medium in the paste.

DESCRIPTION OF REFERENCE SIGNS

1: Base material
2: Pressure-sensitive adhesive layer
3, 3': Thermal bonding sheet
4: Semiconductor wafer
5: Semiconductor chip
6: Adherend
7: Bonding wire
8: Sealing resin
10, 12: Thermal bonding sheet with dicing tape
11: Dicing tape
30: Thermal bonding sheet with both-side separators
31: Precursor layer that is to become a sintered layer by heating
32: First separator
34: Second separator

Claims

1. A thermal bonding sheet comprising a precursor layer that is to become a sintered layer by heating, wherein a weight reduction rate $\Delta W_0$ (%) and a weight reduction rate $\Delta W_{24}$ (%) satisfy a relationship of a formula (3) below,

the weight reduction rate $\Delta W_0$ (%) being represented by a formula (1) below when the thermal bonding sheet is analyzed in a nitrogen atmosphere at a temperature increase rate of 10°C/min from 23°C to 400°C with a differential thermal balance before the thermal bonding sheet is exposed to an atmosphere having a temperature of 23 ± 2°C and a humidity of 50 ± 20%,
the weight reduction rate $\Delta W_{24}$ (%) being represented by a formula (2) below when the thermal bonding sheet is analyzed in a nitrogen atmosphere at a temperature increase rate of 10°C/min from 23°C to 400°C with a differential thermal balance after the thermal bonding sheet is exposed to an atmosphere having a temperature of 23 ± 2°C and a humidity of 50 ± 20% for 24 hours,

$$\Delta W_0 = \{(W_{400} - W_{23})/W_{23}\} \times 100 \ (\%) \ (1)$$

wherein

$W_{23}$ is a weight of the thermal bonding sheet at 23°C before the thermal bonding sheet is exposed to the atmosphere; and
$W_{400}$ is a weight of the thermal bonding sheet at 400°C before the thermal bonding sheet is exposed to the atmosphere,

$$\Delta W_{24} = \{(W'_{400} - W'_{23})/W'_{23}\} \times 100 \ (\%) \ (2)$$

wherein

$W'_{23}$ is a weight of the thermal bonding sheet at 23°C after the thermal bonding sheet is exposed to the atmosphere; and
$W'_{400}$ is a weight of the thermal bonding sheet at 400°C after the thermal bonding sheet is exposed to the atmosphere,

$$-1\% \leq \Delta W_0 - \Delta W_{24} \leq 0.5\% \ (3),$$

wherein the precursor layer contains a thermally decomposable binder which is a solid at 23°C, wherein the thermally decomposable binder which is a solid at 23°C is at least one selected from the group consisting of a polycarbonate resin and an acrylic resin, and
wherein the precursor layer contains 1,6-hexanediol.

2. The thermal bonding sheet according to claim 1, wherein the precursor layer has a tensile elastic modulus at 23°C of 10 to 3000 MPa, wherein the tensile elastic modulus is determined according to the following testing method:

(1) as a test sample, a thermal bonding sheet (thermal bonding sheet for tensile test) having a thickness of 200 $\mu$m, a width of 10 mm, and a length of 40 mm is prepared,
(2) a tensile test is conducted with a distance between chucks of 10 mm, a tensile speed of 50 mm/min, at 23°C, and
(3) the inclination of the linear part of the obtained stress-strain chart is determined as a tensile modulus.

3. The thermal bonding sheet according to claim 1 or 2, wherein

the precursor layer contains metallic fine particles, and
the metallic fine particles are made of at least one selected from the group consisting of silver, copper, silver oxide, and copper oxide.

4. A thermal bonding sheet with dicing tape, comprising:

a dicing tape; and
the thermal bonding sheet according to any one of claims 1 to 3 laminated on the dicing tape.

**Patentansprüche**

1. Thermische Klebefolie, die eine Vorläufer-Schicht umfasst, die durch Erhitzen zu einer gesinterten Schicht werden soll, wobei für eine Gewichts-Verringerungsrate $\Delta W_0$ (%) und eine Gewichts-Verringerungsrate $\Delta W_{24}$ (%) eine Beziehung gemäß einer unten aufgeführten Formel (3) gilt,

die Gewichts-Verringerungsrate $\Delta W_0$ (%) durch eine unten aufgeführte Formel (1) repräsentiert wird, wenn die thermische Klebefolie in einer Stickstoff-Atmosphäre bei einer Temperatur-Erhöhungsgeschwindigkeit von 10 °C/min von 23 °C auf 400 °C mit einer differenziellen Wärmebilanz analysiert wird, bevor die thermische Klebefolie einer Atmosphäre mit einer Temperatur von 23 ± 2 °C und einer Feuchtigkeit von 50 ± 20 % ausgesetzt wird,
die Gewichts-Verringerungsrate $\Delta W_{24}$ (%) durch eine unten aufgeführte Formel (2) repräsentiert wird, wenn die thermische Klebefolie in einer Stickstoff-Atmosphäre bei einer Temperatur-Erhöhungsgeschwindigkeit von 10 °C/min von 23 °C auf 400 °C mit einer differenziellen Wärmebilanz analysiert wird, nachdem die thermische Klebefolie über 24 Stunden einer Atmosphäre mit einer Temperatur von 23 ± 2 °C und einer Feuchtigkeit von 50 ± 20 % ausgesetzt wird,

$$\Delta W_0 = \{(W_{400} - W_{23})/W_{23}\} \times 100 \ (\%) \hspace{2cm} (1)$$

wobei

$W_{23}$ ein Gewicht der thermischen Klebefolie bei 23 °C ist, bevor die thermische Klebefolie der Atmosphäre ausgesetzt wird; und
$W_{400}$ das Gewicht der thermischen Klebefolie bei 400 °C ist, bevor die thermische Klebefolie der Atmosphäre ausgesetzt wird,

$$\Delta W_{24} = \{(W'_{400} - W'_{23})/W'_{23}\} \times 100 \; (\%) \qquad (2)$$

wobei

$W'_{23}$ ein Gewicht der thermischen Klebefolie bei 23 °C ist, nachdem die thermische Klebefolie der Atmosphäre ausgesetzt war; und
$W'_{400}$ ein Gewicht der thermischen Klebefolie bei 400 °C ist, nachdem die thermische Klebefolie der Atmosphäre ausgesetzt war,

$$-1 \; \% \leq \Delta W_0 - \Delta W_{24} \leq 0,5 \; \% \qquad (3),$$

wobei die Vorläufer-Schicht ein thermisch abbaubares Bindemittel enthält, das bei 23 °C ein Feststoff ist, und das thermisch abbaubare Bindemittel, das bei 23 °C ein Feststoff ist, wenigstens Bindemittel ist, das aus der Gruppe ausgewählt wird, die aus einem Polycarbonat-Harz und einem Acryl-Harz besteht, und die Vorläufer-Schicht 1,6-Hexandiol enthält.

2. Thermische Klebefolie nach Anspruch 1, wobei die Vorläufer-Schicht einen Elastizitätsmodul (tensile elastic modulus) bei 23 °C von 10 bis 3000 MPa aufweist, wobei der Elastizitätsmodul gemäß dem folgenden Prüfverfahren bestimmt wird:

(1) Als ein Prüfmuster wird eine thermische Klebefolie (thermische Klebefolie für Zugversuch) mit einer Dicke von 200 $\mu$m, einer Breite von 10 mm und einer Länge von 40 mm gefertigt,
(2) es wird ein Zugversuch mit einem Abstand zwischen Spanneinrichtungen von 10 mm, einer Ziehgeschwindigkeit von 50 mm/min bei 23 °C durchgeführt, und
(3) die Neigung des linearen Teils des sich ergebenden Spannungs-Dehnungs-Diagramms wird als ein Elastizitätsmodul bestimmt.

3. Thermische Klebefolie nach Anspruch 1 oder 2, wobei

die Vorläufer-Schicht feine Metallteilchen enthält, und
die feinen Metallteilchen aus wenigstens einem Material bestehen, das aus der Gruppe ausgewählt wird, die aus Silber, Kupfer, Silberoxid und Kupferoxid besteht.

4. Thermische Klebefolie mit Sägefolie, die umfasst:

eine Sägefolie; und
die thermische Klebefolie nach einem der Ansprüche 1 bis 3, die auf die Sägefolie laminiert ist.

**Revendications**

1. Feuille de thermocollage comprenant une couche précurseur qui doit devenir une couche frittée par chauffage, un taux de réduction massique $\Delta W_0$ (%) et un taux de réduction massique $\Delta W_{24}$ (%) satisfaisant à une relation selon une formule (3) ci-dessous,

le taux de réduction massique $\Delta W_0$ (%) étant représenté par une formule (1) ci-dessous quand la feuille de thermocollage est analysée dans une atmosphère d'azote à une vitesse d'accroissement de la température de 10 °C/min de 23 °C à 400 °C avec une balance thermique différentielle avant que la feuille de thermocollage soit exposée à une atmosphère ayant une température de 23 $\pm$ 2 °C et une humidité de 50 $\pm$ 20 %,

le taux de réduction massique $\Delta W_{24}$ (%) étant représenté par une formule (2) ci-dessous quand la feuille de thermocollage est analysée dans une atmosphère d'azote à une vitesse d'accroissement de la température de 10 °C/min de 23 °C à 400 °C avec une balance thermique différentielle avant que la feuille de thermocollage soit exposée à une atmosphère ayant une température de 23 $\pm$ 2 °C et une humidité de 50 $\pm$ 20 % pendant 24 heures,

$$\Delta W_0 = \{(W_{400} - W_{23})/W_{23}\} \times 100 \ (\%) \ (1)$$

où

$W_{23}$ est une masse de la feuille de thermocollage à 23 °C avant exposition de la feuille de thermocollage à l'atmosphère ; et
$W_{400}$ est une masse de la feuille de thermocollage à 400 °C avant exposition de la feuille de thermocollage à l'atmosphère,

$$\Delta W_{24} = \{(W'_{400} - W'_{23})/W'_{23}\} \times 100 \ (\%) \ (2)$$

où

$W'_{23}$ est une masse de la feuille de thermocollage à 23 °C après exposition de la feuille de thermocollage à l'atmosphère ; et
$W'_{400}$ est une masse de la feuille de thermocollage à 400 °C après exposition de la feuille de thermocollage à l'atmosphère,

$$-1\% \leq \Delta W_0 - \Delta W_{24} \leq 0,5\% \ (3),$$

la couche précurseur contenant un liant décomposable à la chaleur qui est solide à 23 °C, le liant décomposable thermiquement solide à 23 °C étant au moins un composé choisi dans le groupe constitué par une résine de polycarbonate et une résine acrylique, et
la couche précurseur contenant du 1,6-hexanediol.

2. Feuille de thermocollage selon la revendication 1, dans laquelle la couche précurseur a un module élastique de traction à 23 °C de 10 à 3000 MPa, le module élastique de traction étant déterminé selon la méthode d'essai suivante :

(1) comme échantillon d'essai, on prépare une feuille de thermocollage (feuille de thermocollage pour essai de traction) ayant une épaisseur de 200 $\mu$m, une largeur de 10 mm et une longueur de 40 mm,
(2) on réalise un essai de traction avec une distance entre mâchoires de 10 mm, une vitesse de traction de 50 mm/min, à 23 °C, et
(3) on détermine la pente de la partie linéaire de la courbe effort-déformation en tant que module de traction.

3. Feuille de thermocollage selon la revendication 1 ou 2, la couche précurseur contenant de fines particules métalliques, et
les fines particules métalliques étant constituées de l'un au moins parmi de l'argent, du cuivre, un oxyde d'argent et un oxyde de cuivre.

4. Feuille de thermocollage avec ruban de découpage en dés, comprenant

un ruban de découpage en dés ; et
la feuille de thermocollage selon l'une quelconque des revendications stratifiée sur le ruban de découpage en dés.

Fig. 1

Fig. 2

Fig. 3

Fig. 4

**EP 3 517 586 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2014111800 A
- JP 2016121329 A
- JP 60196956 A
- JP 2013007028 A